# FASCICULE DE BREVET EUROPEEN

(11) **EP 1 835 296 B1**
(45) Date de publication et mention de la délivrance du brevet: **09.02.2011**
(21) Numéro de dépôt: 07290297.6
(22) Date de dépôt: 07.03.2007
(51) Int. Cl.: G01R 31/317, H04L 7/033

(54) **Methode de caractérisation d'un instant de détection d'un bit**
Verfahren zur Charakterisierung eines Zeitpunkts der Biterkennung
Method of characterising a bit detection instant

(30) Priorité: 17.03.2006 FR 0602386
(43) Date de publication de la demande: 19.09.2007
(73) Titulaire: STMICROELECTRONICS SA, 92120 Montrouge (FR)
(72) Inventeur: Le-Gall, Hervé, 38410 St Martin d'Uriage (FR); Armagnat, Paul, 38170 Seyssinet (FR); Pont, Jean-Christophe, 38330 Saint Ismier (FR)
(74) Mandataire: Boire, Philippe Maxime Charles

(56) Documents cités:
- US-A- 5 220 581
- US-A- 5 371 766
- US-A1- 2005 025 274
- US-B1- 6 701 140

## Description

La présente invention concerne un procédé de caractérisation d'un instant auquel un bit est détecté au sein d'un circuit électronique intégré. Elle concerne aussi un circuit qui incorpore un récepteur de données binaires ainsi qu'un module de test de ce récepteur.

Lorsqu'un circuit électronique intégré est fabriqué, qui incorpore un récepteur de données binaires, il est nécessaire de vérifier le fonctionnement de ce dernier pour chaque unité de circuit produite. En particulier, il est nécessaire de vérifier que des données transmises au récepteur sont correctement détectées. Ceci est le cas, notamment, lorsque la réception des données est effectuée selon la norme HDMI, pour «High-Definition Multimedia Interface» en anglais.

Or, l'instant de détection d'un bit reçu peut varier à l'intérieur d'une période de lecture du bit, notamment à cause de perturbations extérieures. De telles variations sont susceptibles d'entraîner une erreur de détection du bit. Pour cette raison, la répartition statistique des instants de détection dans des périodes de lecture successives doit être déterminée lors de tests de fonctionnement du circuit.

Pour réaliser ces tests, un module spécifique est ajouté au circuit électronique intégré, qui est couramment appelé BIST, pour «Built-In Self-Test». Ce module, qui est inutile pendant l'utilisation du circuit selon la fonction pour laquelle il est prévu, provoque néanmoins un surcoût pour le circuit. Il est donc avantageux de concevoir un BIST simple, et notamment un BIST qui occupe une surface de substrat de circuit électronique intégré aussi réduite que possible.

Le test de chaque unité de circuit produite est effectué en utilisant un appareil de contrôle spécifique, appelé testeur, dont le prix varie considérablement en fonction des exigences techniques requises pour celui-ci. Par exemple, un testeur qui fonctionne à une vitesse de 320 Mbit/s est beaucoup moins onéreux qu'un testeur à 1,6 Gbit/s. En fait, l'exigence sur les performances du testeur dépend des fonctions qui sont réalisées au sein du BIST, si bien qu'un compromis est recherché entre un BIST simplifié et la nécessité d'utiliser un testeur onéreux.

Pour déterminer la répartition statistique d'instants de détection de bits situés à l'intérieur de périodes de lecture successives, il est nécessaire de découper d'une même façon chaque période de lecture en intervalles de temps élémentaires, et de compter le nombre de fois où un bit est détecté dans chaque intervalle du découpage. Or une vitesse de système qui correspond aux intervalles de temps élémentaires du découpage est élevée. Pour éviter d'utiliser un testeur qui fonctionne à une telle vitesse, il est connu de créer ces intervalles élémentaires en utilisant deux fréquences qui présentent entre elles un faible écart, respectivement pour cadencer les périodes de lecture et pour déclencher la détection des bits. Ainsi, le testeur génère un signal de déclenchement de la détection de bit à une première fréquence, et génère un signal binaire à une seconde fréquence légèrement différente. Le signal à la seconde fréquence est synthétisé au sein du testeur à partir du signal à la première fréquence, avec une précision suffisante pour définir les intervalles de temps élémentaires du découpage des périodes de lecture par le décalage progressif qui apparaît entre les deux signaux. Le signal à la seconde fréquence correspond aux bits détectés par le récepteur du circuit lors du test.

Le document US-B1-6 701 140 décrit un tel procédé de caractérisation d'un instant de détection de bit.

Mais compter le nombre de fois où un bit est détecté dans chaque intervalle de temps élémentaire du découpage nécessite de transmettre le bit un nombre déterminé de fois, par exemple 256 fois, alors que la détection est recherchée dans un intervalle élémentaire donné. La même opération doit ensuite être répétée pour chaque intervalle élémentaire. Il en résulte une durée de test importante, qui contribue à augmenter le prix de revient de chaque unité de circuit électronique produite.

Un but de la présente invention est de caractériser la répartition statistique des instants de détection de bit, en réalisant un compromis amélioré entre un BIST simplifié d'une part, un testeur pas trop onéreux d'autre part, et une durée de test limitée par ailleurs.

Pour cela, l'invention propose un procédé de caractérisation d'un instant de détection d'un bit à l'intérieur d'une période de lecture du bit, suivant lequel plusieurs périodes de lecture sont découpées d'une même façon en un nombre fixe d'intervalles de temps élémentaires. Ces intervalles élémentaires sont définis par un écart entre une fréquence correspondant à la période de lecture et une fréquence selon laquelle une détection de bit est cadencée. En outre, le procédé comprend les étapes suivantes :
/a/ identifier un premier intervalle de temps élémentaire pour lequel une probabilité pour qu'un instant de détection survienne dans ce premier intervalle soit non nulle ;
/b/ à partir de ce premier intervalle élémentaire, sélectionner une fenêtre de temps comprenant plusieurs intervalles élémentaires successifs, la fenêtre étant plus courte qu'une période de lecture et contenant une proportion importante des instants de détection ;
/c/ répéter le bit plusieurs fois d'une façon identique dans des périodes de lecture correspondantes, et compter le nombre de fois où un bit est détecté pendant chaque intervalle de temps élémentaire qui est situé dans la fenêtre, aucun décompte de bit détecté n'étant effectué pour un intervalle de temps élémentaire qui est situé en dehors de la fenêtre.

Les décomptes effectués pour les intervalles de temps élémentaires qui sont situés dans la fenêtre caractérisent alors une partie de la répartition statistique des instants de détection de bit à l'intérieur des périodes de lecture.

Ainsi, selon l'invention, le nombre de fois où un bit est détecté dans chaque intervalle élémentaire du découpage des périodes de lecture n'est décompté que pour ceux de ces intervalles élémentaires qui sont situés dans la fenêtre de temps sélectionnée. Etant donné que des compteurs différents sont nécessaires pour tous les intervalles élémentaires pour lesquels des décomptes sont effectués simultanément, la limitation des décomptes effectués aux intervalles de la fenêtre permet de réduire le nombre de compteurs nécessaires.

En outre, lorsque des décomptes sont effectués à l'étape /c/ simultanément pour plusieurs intervalles de la fenêtre, la durée de test nécessaire est diminuée sensiblement en proportion avec le rapport du nombre d'intervalles élémentaires compris dans la fenêtre, par rapport à des décomptes réalisés un par un.

En outre, limiter selon l'invention la caractérisation de la répartition statistique des instants de détection à l'intérieur d'une fenêtre de temps plus courte que les périodes de lecture n'entraîne pas de perte d'information significative concernant cette répartition statistique. En effet, grâce aux étapes /a/ et /b/ qui sont exécutées en premier lieu, la fenêtre est sélectionnée de sorte qu'une proportion importante des instants de détection sont situés dans cette fenêtre. Autrement dit, les instants de détection qui sont situés en dehors de la fenêtre ne sont pas pris en compte dans la caractérisation qui est réalisée, mais de tels instants qui sont en proportion limitée ne contribuent pas significativement à la répartition statistique globale des instants de détection.

Par ailleurs, un avantage d'un procédé de caractérisation selon l'invention résulte du fait que les intervalles de temps élémentaires qui sont utilisés pour déterminer la répartition statistique des instants de détection sont définis par un écart entre la fréquence qui correspond à la période de lecture des bits et la fréquence selon laquelle une détection de bit est cadencée. Le procédé peut alors être mis en oeuvre en utilisant un testeur de circuits électroniques qui possède une vitesse correspondant sensiblement à la période de lecture des bits. Le prix d'un tel testeur est réduit, par rapport à celui d'un testeur qui aurait une vitesse correspondant aux intervalles de temps élémentaires.

Enfin, un procédé de caractérisation selon l'invention ne nécessite pas que les circuits testés soient pourvus de modules de tests embarqués, ou BIST, qui soient complexes. En particulier, le module de test d'un circuit testé de cette façon peut ne comprendre que des composants logiques peu complexes. Le surcoût de chaque unité de circuit produite qui est engendré par le module de test est alors limité.

Un procédé selon l'invention peut comprendre en outre une évaluation d'une valeur moyenne et/ou d'un écart-type de l'instant de détection à l'intérieur de chaque période de lecture. D'autres grandeurs caractéristiques de la répartition statistique de l'instant de détection peuvent aussi être évaluées. De telles évaluations sont réalisées à partir des nombres de fois où un bit est détecté pendant chaque intervalle de temps élémentaire qui est situé dans la fenêtre.

Selon un premier perfectionnement de l'invention, l'étape /c/ est répétée en utilisant des fenêtres successives sélectionnées pour réaliser un balayage d'une partie de période de lecture. Une partie plus grande de la répartition statistique des instants de détection de bit à l'intérieur des périodes de lecture peut ainsi être obtenue, sans que la complexité du module de test du circuit testé nécessite d'être augmentée significativement. Avantageusement, un dernier intervalle élémentaire de la partie de période de lecture qui correspond au balayage est sélectionné de sorte qu'une probabilité pour qu'un instant de détection survienne dans ce dernier intervalle soit non nulle. En outre, le dernier intervalle est aussi sélectionné de sorte qu'une proportion importante des instants de détection surviennent entre le premier et le dernier intervalles dans les périodes de lecture correspondantes.

Selon un second perfectionnement de l'invention, un compteur différent est associé à l'étape /c/ à chaque intervalle élémentaire situé dans la fenêtre, et, à chaque période de lecture, une affectation des compteurs aux intervalles est modifiée en fonction de l'écart entre la fréquence correspondant à la période de lecture et la fréquence de détection. Les décomptes qui sont effectués pour tous les intervalles élémentaires qui sont situés dans une même fenêtre peuvent alors être réalisés simultanément ou, autrement dit, en parallèle. La durée nécessaire pour caractériser la répartition statistique des instants de détection de bit est alors réduite.

L'invention concerne aussi un procédé de test d'un circuit électronique intégré qui incorpore un récepteur de données binaires, le procédé de test comprenant une caractérisation d'un instant de détection de bit telle que décrite précédemment.

Elle concerne aussi un circuit électronique intégré qui incorpore un récepteur de données binaires transmises par au moins une ligne de bit, et un module de test de ce récepteur, le module étant adapté pour mettre en oeuvre un procédé tel que décrit précédemment pour caractériser un instant de détection d'un bit transmis par la ligne de bit.

En particulier, le récepteur peut être conforme à la norme HDMI. Il peut comprendre une boucle à verrouillage de phase et, pour chaque ligne de bit, au moins un comparateur connecté en entrée à la ligne de bit. La boucle à verrouillage de phase est alors adaptée pour délivrer un signal de déclenchement au comparateur à chaque période d'un signal d'horloge, à un instant déterminé au cours de celle-ci.

D'autres particularités et avantages de la présente invention apparaîtront dans la description ci-après d'un exemple de mise en oeuvre non limitatif, en référence aux dessins annexés, dans lesquels :
- la figure 1 illustre l'architecture d'un circuit électronique intégré pour lequel un procédé de caractérisation selon l'invention peut être utilisé ;
- les figures 2a-2f, destinées à être mises en correspondance entre elles, illustrent le principe d'acquisition de données de caractérisation d'un instant de détection, qui est utilisé dans un procédé selon l'invention ; et
- la figure 3 illustre une architecture de BIST adapté pour mettre en oeuvre un procédé selon l'invention.

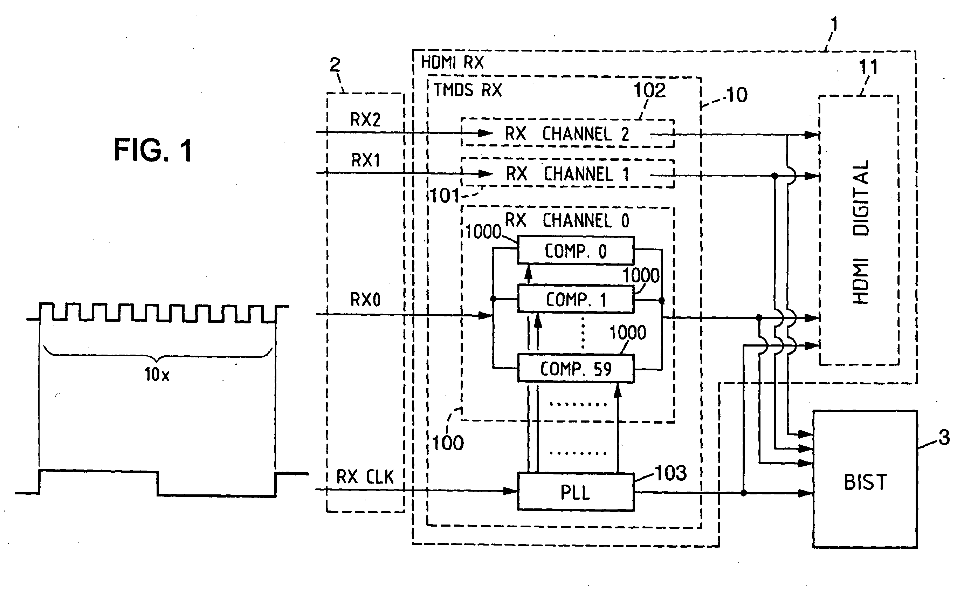

Conformément à la figure 1, un circuit électronique intégré incorpore un récepteur 1 de données binaires transmises par une connexion 2, et un module 3 de test du récepteur 1. Le module 3 est couramment appelé BIST. Le récepteur 1 et le BIST 3 sont réalisés sur un même substrat de circuit électronique intégré.

Le récepteur 1 peut être du type HDMI, et est noté HDMI RX sur la figure 1. D'une façon connue, il comprend un étage de réception TMDS, référencé 10 et noté TMDS RX, et un module 11 de traitement numérique des données reçues, noté HDMI Digital. L'étage de réception 10 comprend lui-même plusieurs canaux de réception, par exemple trois canaux 100, 101, 102, respectivement notés RX Channel 0, RX Channel 1 et RX Channel 2, et une bouche à verrouillage de phase 103, notée PLL pour «Phase Locked Loop» en anglais. Les trois canaux 100-102 sont connectés en entrée respectivement à trois lignes de bit notées RX 0, RX 1 et RX 2, et en sortie au module 11. La bouche à verrouillage de phase 103 est connectée en entrée à une ligne d'horloge, notée RX CLK et en sortie au module 11. Les lignes RX 0, RX 1, RX 2 et RX CLK constitue la connexion 2 par laquelle des données binaires sont transmises au récepteur 1.

Chaque canal de réception 100-102 comprend 60 comparateurs, notés COMP. 0, COMP. 1,..., COMP 59 et référencés 1000. Les trois canaux 100-102 sont identiques, de sorte que l'invention est décrite dans la suite en référence à un seul canal, par exemple le canal 100 (RX Channel 0).

La boucle à verrouillage de phase 103 est adaptée pour produire 60 signaux de déclenchement («tap» en anglais) répartis dans chaque période du signal d'horloge reçu par la ligne RX CLK. Chaque signal de déclenchement est produit à un instant déterminé dans la période du signal d'horloge. Les 60 signaux de déclenchement sont respectivement délivrés aux comparateurs 1000 de chaque canal de réception 100-102 par des connexions dédiées. La réception par un comparateur 1000 d'un signal de déclenchement provoque la détection d'un bit transmis par la ligne de bit correspondante. L'instant de détection du bit à l'intérieur d'une période de lecture de celui-ci est donc déterminé par le signal de déclenchement qui est transmis au comparateur sélectionné pour la lecture de ce bit, pour le canal de réception considéré.

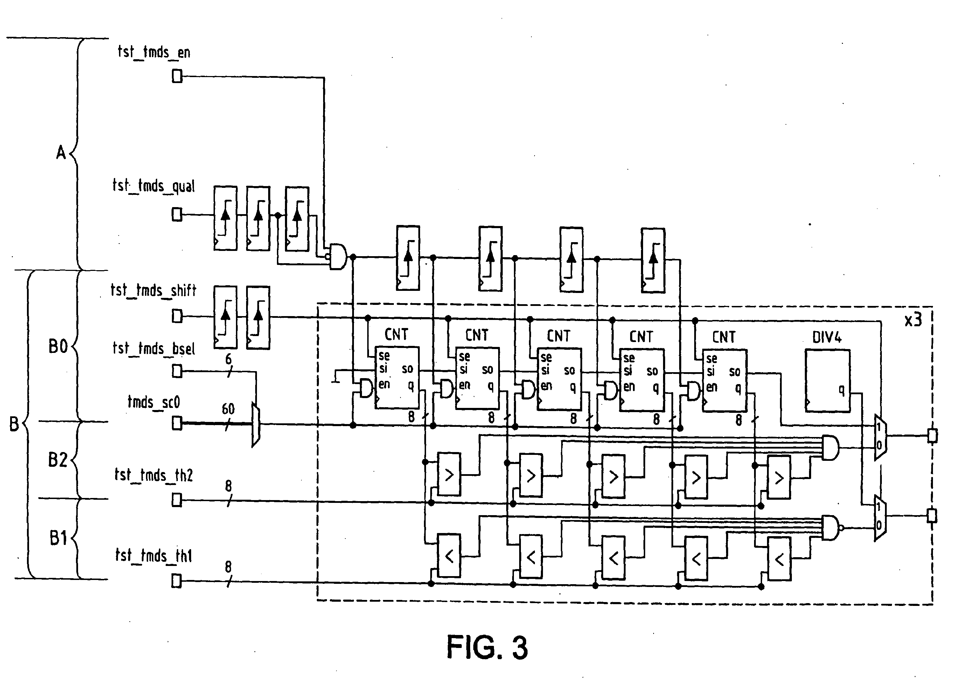

Le BIST 3 est connecté en entrée aux sorties respectives des trois canaux de réception 100-102, ainsi qu'à une sortie de la boucle à verrouillage de phase 103. Il comprend trois ensembles de sélection et de comptage qui sont respectivement associés aux trois lignes de bits et canaux de réception 100-102 associés. Chaque ensemble est agencé pour caractériser l'instant de détection d'un bit transmis par la ligne de bit correspondante. Une réalisation du BIST 3 sera décrite plus loin, en relation avec la figure 3.

Selon la norme TMDS, la période du signal d'horloge qui est transmis sur la ligne RX CLK est égale à 10 fois la période de transmission d'un bit sur l'une des lignes RX 0, RX 1 ou RX 2, pour un fonctionnement normal du circuit.

Pour caractériser les instants de détection d'un bit par l'un des canaux 100-102, un testeur (non représenté) extérieur au circuit est connecté à celui-ci. Ce testeur transmet un signal d'horloge de fréquence f_{C} = 165,000 Mhz sur la ligne RX CLK, et un signal de données rectangulaire de fréquence f_{D} = 165,275 Mhz sur la ligne de bus du canal testé, par exemple du canal 100. Ce signal de données définit des périodes de lecture successives, pendant chacune desquelles un bit peut être détecté. La durée des périodes de lecture est T_{D} = 1/f_{D} = 6,051 ns (nanoseconde). La période associée à f_{C} étant de 6,061 ns, un décalage supplémentaire de 10 ps (picoseconde) apparaît entre le signal d'horloge et le signal de données, à chaque nouvelle période de lecture.

De façon connue, les deux signaux d'horloge et de données, respectivement aux fréquences f_{C} et f_{D}, se retrouvent périodiquement dans un même état de phase relatif, selon une fréquence de battement de f_{B} = 275 kHz. Le décalage entre le signal d'horloge et le signal de données qui apparaît à chaque nouvelle période de lecture définit alors une division fixe des périodes de lecture en intervalles de temps élémentaires, lorsque qu'on considère une succession de périodes de lecture qui correspond à la durée d'un battement entre les deux fréquences f_{C} et f_{D}. Chaque intervalle de temps élémentaire a donc une durée égale à 10 ps. La période de battement T_{B} = 1/f_{B} = 3,6 µs correspond à la durée d'un balayage de la période de lecture avec un pas qui correspond aux intervalles de temps élémentaires définis par l'écart entre les fréquences f_{C} et f_{D}.

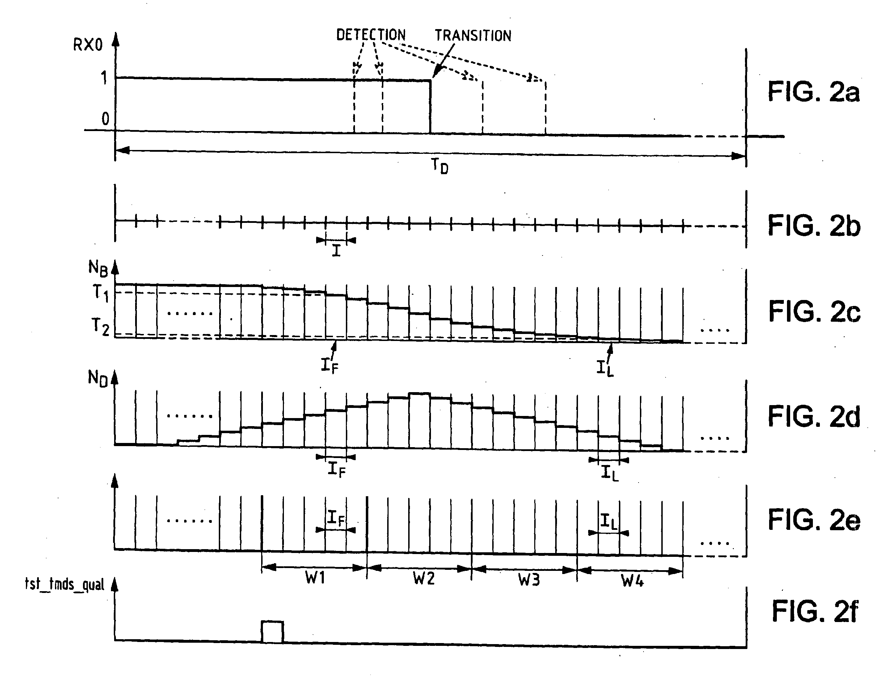

La figure 2a illustre un bit du signal de données RX 0 à l'intérieur d'une période de lecture T_{D}. Une transition de ce bit, par exemple une transition descendante, intervient à instant qui est défini avec précision par le testeur à l'intérieur la période de lecture T_{D}. L'instant de la détection du bit qui est commandée par la boucle à verrouillage de phase 103 peut varier dans la période T_{D} de sorte que le résultat de lecture peut être 1 ou 0, selon si l'instant de lecture effective est situé avant ou après l'instant de transition du bit. Pour permettre de caractériser la répartition statistique des instants de détection, le signal de données qui est transmis par le testeur sur la ligne de bit RX 0 possède une précision suffisante. Du fait de la forme rectangulaire de ce signal, le bit est répété d'une façon identique dans les périodes de lecture successives.

La figure 2b représente le découpage de la période de lecture T_{D} en intervalles de temps élémentaires, notés I. Pour les durées respectives de la période T_{D} et de chaque intervalle I qui ont été citées précédemment, chaque période de lecture T_{D} est découpée en 605 intervalles élémentaires I.

La figure 2c est un histogramme des nombres de fois où un bit pourrait être détecté pour chaque intervalle I, si des décomptes étaient effectués pour tous les intervalles I pendan une durée d'acquisition correspondant à un nombre déterminé de périodes de battement T_{B}.

La figure 2d est un histogramme déduit de celui de la figure 2c. Il représente les écarts entre les nombres décomptés pour deux intervalles I successifs. L'histogramme de la figure 2d caractérise donc la répartition statistique des instants de détection dans la période de lecture T_{D}. Le nombre ainsi obtenu d'instants de détection qui sont survenus dans chaque intervalle I est noté N_{D}.

Un procédé selon l'invention pour l'acquisition de données se rapportant à la répartition des instants de détection de bit à l'intérieur des périodes de lecture est maintenant décrit.

Lors d'une première étape, un premier intervalle de temps élémentaire du découpage de chaque période de lecture est recherché, pour lequel un instant de détection de bit peut intervenir avec une probabilité significative. Pour cela, une acquisition est effectuée pendant plusieurs périodes de battement T_{B}, lors desquelles le bit est répété de façon identique à chaque période de lecture T_{D}. Le nombre de fois où un bit est détecté dans un intervalle de temps élémentaire sélectionné a priori est alors compté. Ce nombre est noté N_{B} sur la figure 2c. Si le BIST 3 comprend plusieurs compteurs, par exemple cinq compteurs, de tels décomptes peuvent être effectués en parallèle pour cinq intervalles de temps élémentaires I successifs.

Selon une méthode préférée de recherche d'un intervalle élémentaire qui contient au moins un instant de détection, on compte le nombre N_{B} de fois où un bit est détecté dans l'intervalle sélectionné a priori, et on compare le nombre obtenu à un premier seuil, noté T₁ sur la figure 2c. Un nombre N_{B} qui est supérieur au seuil T₁ signifie que l'intervalle élémentaire est situé trop tôt à l'intérieur des périodes de lecture T_{D}. A l'inverse, un nombre N_{B} qui est inférieur au seuil T₁ signifie que l'intervalle élémentaire est situé trop tard à l'intérieur des périodes de lecture T_{D}. Cinq nombres N_{B} obtenus lors d'une même période d'acquisition pour cinq intervalles élémentaires l considéré simultanément sont comparés au seuil T₁. Si l'un d'eux est suffisamment proche de ce seuil, l'intervalle correspondant est sélectionné comme premier intervalle, ou point de départ, du balayage d'une partie des périodes de lecture T_{D}. Si les nombres N_{B} obtenus pour les cinq intervalles considérés simultanément sont éloignés du seuil T₁, alors la première étape est répétée pour une nouvelle série de cinq intervalles de temps élémentaires. Les nombres N_{B} obtenus pour la première série de cinq intervalles sont avantageusement utilisés pour choisir les cinq intervalles de la nouvelle série. A l'issue de la première étape du procédé, un premier intervalle du découpage de chaque période de lecture T_{D} est donc sélectionné. Il est noté I_{F} sur les figures 2c-2e.

Avantageusement, un dernier intervalle élémentaire de la partie de période de lecture qui correspond au balayage des périodes de lecture T_{D} peut aussi être sélectionné. Ce dernier intervalle, noté I_{L} sur les figures 2c-2e, peut aussi correspondre à une probabilité pour qu'un instant de détection survienne dans cet intervalle soit non nulle. Il peut être sélectionné d'une façon similaire au premier intervalle I_{F}. En particulier, le dernier intervalle I_{L} peut aussi être sélectionné en répétant le bit plusieurs fois d'une façon identique dans des périodes de lecture correspondantes pendant plusieurs périodes de battement T_{B}, en comptant le nombre N_{B} de fois où un bit est détecté dans cet intervalle, et en comparant le nombre obtenu à un second seuil T₂.

Les seuils T₁ et T₂ peuvent être stockés dans un élément de mémoire morte du BIST 3, par exemple sous forme d'un mot de 8 bits. Alternativement, ils peuvent être programmés au moyen du testeur et transmis au BIST 3 par des connexions dédiées (voir figure 3). A titre d'exemple, les seuils T₁ et T₂ peuvent être égaux respectivement à 10% et 90% du nombre de périodes de battement T_{B} qui correspond à la durée d'acquisition.

Il est entendu que, de façon équivalente, le premier intervalle de temps élémentaire l_{F} peut être recherché en considérant des transitions de bit montantes. Il en est de même pour dernier intervalle élémentaire l_{L}.

Lors d'une deuxième étape du procédé, une fenêtre de temps qui comprend plusieurs intervalles l successifs est sélectionnée, pour être appliquée à chaque période de lecture T_{D}. L'intervalle l_{F} et/ou l'intervalle l_{L} sert(servent) pour sélectionner la fenêtre. Selon un mode opératoire particulier, les intervalles l_{F} et l_{L} correspondent aux bornes de la fenêtre. Selon un autre mode opératoire, la fenêtre est sélectionnée à partir de l'un des intervalles l_{F} et l_{L}, et possède une longueur fixe. Selon encore un autre mode opératoire, la fenêtre peut être située par rapport aux intervalles l_{F} et l_{L} selon des règles préétablies, sans que ces intervalles correspondent au début ou à la fin de la fenêtre.

Lors d'une troisième étape du procédé, un balayage des intervalles de temps I compris dans la fenêtre est réalisé, afin de déterminer le nombre de fois où un bit est détecté au cours de chacun de ces intervalles. Pour cela, un détecteur et un compteur différents sont associés à chaque intervalle élémentaire I situé dans la fenêtre et, à chaque nouvelle période de lecture T_{D}, une affectation des compteurs aux détecteurs est modifiée en fonction de l'écart entre les fréquences f_{C} et f_{D}.

Selon un mode de mise en oeuvre préféré de l'invention, le balayage d'une partie de la période de lecture T_{D} est réalisé en utilisant plusieurs fenêtres successives sélectionnées à partir des intervalles élémentaires I_{F} et I_{L}. A titre d'exemple, quatre fenêtres successives, notées W1-W4 sur la figure 2e, peuvent être sélectionnées pour réaliser le balayage de la partie de période de lecture. Chaque fenêtre W1,...,W4 peut comprendre plusieurs intervalles élémentaires I, par exemple cinq intervalles, en fonction du nombre de compteurs que comporte le BIST 3 pour chaque canal de réception. D'une façon optimale, le nombre d'intervalles de chaque fenêtre, pour lesquels les nombres de bits détectés sont comptés simultanément, est égal au nombre de compteurs du BIST 3 pour ce canal.

Pour chacune des fenêtres W1,...,W4, la durée d'acquisition pour compter les nombres de bits détectés dans chaque intervalle l de cette fenêtre, peut être égal à 256/n périodes T_{B}, où n désigne le nombre d'intervalles l dans chaque fenêtre. Etant donné qu'à chaque période T_{B}, le bit est répété utilement pendant n périodes de lecture T_{D}, 256 répétitions du bit correspondent à des détections utiles pour caractériser la répartition des instants de détection.

La troisième étape de décompte des bits détectés est répétée pour chacune des quatre fenêtres W1-W4.

Une fois que l'histogramme de la figure 2d a été obtenu dans la partie de période T_{D} qui correspond aux quatre fenêtres W1-W4, plusieurs grandeurs statistiques peuvent être évaluées à partir des nombres N_{D}. Parmi ces grandeurs, la valeur moyenne et l'écart-type de l'instant de détection peuvent être calculés, d'une façon connue de l'Homme du métier.

Lorsque des histogrammes de caractérisation de l'instant de détection sont enregistrés pour chacun des comparateurs 1000 d'un canal de réception fixé, il est alors possible de caractériser la répartition des valeurs moyennes des instants de détection associés à ces comparateurs à l'intérieur d'une période de lecture T_{D}. Une telle caractérisation du canal est usuellement appelée «linéarité» des instants de détection du canal.

Selon un perfectionnement de l'invention, plusieurs caractérisations d'instants de réception de bit peuvent être effectuées simultanément, respectivement pour plusieurs canaux de réception qui sont disposés en parallèle au sein du circuit électronique intégré, en utilisant des mêmes signaux de déclenchement de détection de bit pour ces canaux de réception. Pour le circuit de la figure 1, les instants de détection de bit des canaux 100, 101 et 102 peuvent ainsi être caractérisés simultanément. Pour cela, la boucle à verrouillage de phase 103 est connectée aux comparateurs 1000 des lignes de bit selon une association en parallèle entre ces lignes. Les signaux de déclenchement sont alors délivrés simultanément aux comparateurs associés en parallèle. Le BIST 3 est aussi adapté pour caractériser simultanément les instants de détection de bits qui sont transmis respectivement par les lignes RX0, RX1 et RX2.

La figure 3 représente une architecture possible pour le BIST 3. Celui-ci comprend une partie de contrôle, notée A, et trois ensembles de sélection et de comptage, notés B et respectivement associés aux trois lignes de bit RX 0, RX 1 et RX 2. Chacun des ensembles B comprend une chaîne de cinq compteurs, notée BO, et deux chaînes de comparateurs, respectivement B1 et B2. Les chaînes B1 et B2 permettent de comparer les résultats des compteurs de la chaîne B0 aux seuils T₁ et T₂, respectivement, pour sélectionner les intervalles l_{F} et l_{L}. Un mode conventionnel de représentation des composants logiques a été adopté pour la figure 3, qui est connu de l'Homme du métier. Les signaux d'entrée indiqués sont les suivants :
tmds_sc0 : signal rectangulaire transmis par le testeur sur chaque ligne de bit RX 0, RX 1 et RX 2 ;
tst_tmds_bsel : signal de sélection d'un des comparateurs 1000 pour le test en cours, transmis par le testeur ;
tst_tmds_th1 : seuil T₁ programmé au moyen du testeur ;
tst_tmds_th2 : seuil T₂ programmé au moyen du testeur ;
tst_tmds_shift : signal d'horloge RX CLK transmis par la boucle à verrouillage de phase 103 ;
tst_tmds_qua! : signal de déclenchement des décomptes pour les intervalles élémentaires compris dans la fenêtre de balayage. Ce signal est représenté à la figure 2f pour la fenêtre W1 ; et
tst_tmds_en : signal d'activation du test du récepteur 10.

Il est entendu que l'architecture illustrée à la figure 3 n'est donnée qu'à titre d'exemple, et que des architectures équivalentes peuvent être conçues pour mettre en oeuvre un procédé selon l'invention. Enfin, des modifications peuvent aussi être introduites dans l'exemple de mise en oeuvre de l'invention qui a été décrit en détail, tout en conservant une partie au moins des avantages de l'invention, à savoir :
- la compatibilité du procédé de caractérisation de l'instant de détection d'un bit avec l'utilisation d'un testeur peu onéreux ;
- la compatibilité du procédé avec un BIST simple qui n'engendre pas d'augmentation notable du prix de revient de chaque unité produite du circuit électronique ; et
- une durée des tests de chaque unité de circuit qui est limitée.

## Revendications

1. Procédé de caractérisation d'un instant de détection d'un bit à l'intérieur d'une période (T_{D}) de lecture dudit bit, suivant lequel plusieurs périodes de lecture sont découpées d'une même façon en un nombre fixe d'intervalles de temps élémentaires (I) définis par un écart entre une fréquence correspondant à la période de lecture et une fréquence selon laquelle une détection de bit est cadencée, le procédé comprenant les étapes suivantes :
/a/ identifier un premier intervalle de temps élémentaire (I_{F}) pour lequel une probabilité pour qu'un instant de détection de bit survienne dans ledit premier intervalle soit non nulle ;
/b/ à partir dudit premier intervalle élémentaire (I_{F}), sélectionner une fenêtre de temps (W1) comprenant plusieurs intervalles élémentaires successifs (I), ladite fenêtre étant plus courte qu'une période de lecture (T_{D}) et contenant une proportion importante des instants de détection ;
/c/ répéter le bit plusieurs fois d'une façon identique dans des périodes de lecture correspondantes, et compter le nombre (N_{B}) de fois où un bit est détecté pendant chaque intervalle de temps élémentaire situé dans la fenêtre (W1), aucun décompte de bit détecté n'étant effectué pour un intervalle de temps élémentaire situé en dehors de la fenêtre,
les décomptes effectués pour les intervalles élémentaires situés dans la fenêtre caractérisant une partie d'une répartition statistique des instants de détection de bit à l'intérieur des périodes de lecture.

2. Procédé selon la revendication 1, suivant lequel le premier intervalle élémentaire (I_{F}) est sélectionné en répétant le bit plusieurs fois d'une façon identique dans des périodes de lecture correspondantes (T_{D}), en comptant le nombre (N_{B}) de fois où un bit est détecté dans ledit premier intervalle et en comparant le nombre obtenu à un premier seuil (T₁).

3. Procédé selon la revendication 1 ou 2, suivant lequel l'étape /c/ est répétée en utilisant des fenêtres successives (W1-W4) sélectionnées pour réaliser un balayage d'une partie de période de lecture (T_{D}).

4. Procédé selon la revendication 3, suivant lequel un dernier intervalle élémentaire (I_{L}) de la partie de période de lecture correspondant au balayage est sélectionné de sorte qu'une probabilité pour qu'un instant de détection survienne dans ledit dernier intervalle soit non nulle, une proportion importante des instants de détection survenant entre lesdits premier (I_{F}) et dernier (I_{L}) intervalles dans les périodes de lecture (T_{D}) correspondantes.

5. Procédé selon la revendication 4, suivant lequel ledit dernier intervalle élémentaire (I_{L}) est sélectionné en répétant le bit plusieurs fois d'une façon identique dans des périodes de lecture correspondantes (T_{D}), en comptant le nombre (N_{B}) de fois où un bit est détecté dans ledit dernier intervalle et en comparant le nombre obtenu à un second seuil (T₂).

6. Procédé selon l'une quelconque des revendications précédentes, comprenant en outre une évaluation d'une valeur moyenne de l'instant de détection à l'intérieur de chaque période de lecture (T_{D}).

7. Procédé selon l'une quelconque des revendications précédentes, comprenant en outre une évaluation d'un écart-type de l'instant de détection à l'intérieur de chaque période de lecture (T_{D}).

8. Procédé selon l'une quelconque des revendications précédentes, suivant lequel, à l'étape /c/, un compteur différent est associé à chaque intervalle élémentaire (1) situé dans la fenêtre (W1), et suivant lequel, à chaque période de lecture (T_{D}), une affectation des compteurs aux intervalles est modifiée en fonction de l'écart entre la fréquence correspondant à la période de lecture et la fréquence de détection.

9. Procédé selon l'une quelconque des revendications précédentes, suivant lequel chaque fenêtre sélectionnée (W1-W4) comprend cinq intervalles élémentaires (I).

10. Procédé selon l'une quelconque des revendications précédentes, suivant lequel la fréquence correspondant à la période de lecture et la fréquence de détection sont respectivement 165,275 Mhz et 165,000 MHz.

11. Procédé selon l'une quelconque des revendications précédentes, suivant lequel, à l'étape /c/, le bit est répété au moins 256 fois.

12. Procédé selon l'une quelconque des revendications précédentes, suivant lequel l'étape /c/ est répétée quatre fois en utilisant quatre fenêtres successives (W1-W4) sélectionnées pour réaliser un balayage d'une partie de période de lecture (T_{D}).

13. Procédé de test d'un circuit électronique intégré incorporant un récepteur de données binaires (1), ledit procédé de test comprenant une caractérisation d'un instant de détection d'un bit effectuée selon l'une quelconque des revendications 1 à 12.

14. Procédé selon la revendication 13, mis en oeuvre pour un circuit incorporant un récepteur (1) conforme à la norme HDMI.

15. Procédé selon la revendication 13 ou 14, suivant lequel plusieurs caractérisations d'instants de réception de bit sont effectuées simultanément, respectivement pour plusieurs canaux de réception (100, 101, 102) disposés en parallèle au sein dudit circuit électronique intégré, en utilisant des mêmes signaux de déclenchement de détection de bit pour lesdits canaux de réception.

16. Circuit électronique intégré incorporant un récepteur (1) de données binaires transmises par au moins une ligne de bit (2), et un module (3) de test dudit récepteur, le module étant configuré pour mettre en oeuvre un procédé de caractérisation d'un instant de détection d'un bit transmis par ladite ligne selon l'une quelconque des revendications 1 à 12.

17. Circuit selon la revendication 16, dans lequel le récepteur (1) est conforme à la norme HDMI.

18. Circuit selon la revendication 16 ou 17, dans lequel le récepteur (1) comprend un bus à trois lignes de bit (2), et dans lequel le module de test (3) comprend trois ensembles de sélection et de comptage (B) respectivement associés aux trois lignes de bit, chaque ensemble étant agencé pour mettre en oeuvre le procédé de caractérisation d'un instant de détection pour un bit transmis par la ligne correspondante.

19. Circuit selon l'une quelconque des revendications 16 à 18, dans lequel le récepteur (1) comprend une boucle à verrouillage de phase (103) et, pour chaque ligne de bit, au moins un comparateur (1000) connecté en entrée à la ligne de bit, la boucle à verrouillage de phase étant adaptée pour délivrer un signal de déclenchement au comparateur à chaque période d'un signal d'horloge, à un instant déterminé dans ladite période du signal d'horloge.

20. Circuit selon la revendication 19, dans lequel le récepteur (1) comprend, pour chaque ligne de bit, soixante comparateurs (1000) connectés en entrée à ladite ligne de bit, la boucle à verrouillage de phase (103) étant agencée pour délivrer aux comparateurs des signaux de déclenchement respectifs répartis dans la période du signal d'horloge.

21. Circuit selon la revendication 19 ou 20, dans lequel la boucle à verrouillage de phase (103) est connectée aux comparateurs (1000) de plusieurs lignes de bit, selon une association en parallèle entre lesdites lignes de bit, de façon à délivrer des signaux de déclenchement simultanément aux comparateurs associés en parallèle, et dans lequel le modulé de test (3) est adapté pour caractériser simultanément les instants de détection de bits transmis respectivement par lesdites lignes.

## Claims

1. A method for characterizing a bit detection event time within a read period (T_{D}) of said bit, wherein several read periods are sub-divided in a same fashion into a fixed number of elementary time intervals (I) defined by a difference between a frequency corresponding to the read period and a frequency according to which a bit detection is timed, the method comprising:
/a/ identifying a first elementary time interval (IF) for which a probability that a bit detection event time occurs within said first interval is non-zero;
/b/ starting from said first elementary time interval (IF), selecting a time window (W1) comprising several successive elementary time intervals (I), said time window being shorter than a read period (T_{D}) and containing a large proportion of the detection event times;
/c/ repeating the bit several times in an identical fashion within corresponding read periods, and counting the number (N_{B}) of times where a bit is detected during each elementary time interval situated within the window (W1), no counting of detected bit being carried out for an elementary time interval situated outside said window,
the counting operations carried out for the elementary time intervals situated within the window characterizing part of a statistical distribution of the bit detection event times within the read periods.

2. The method according to Claim 1, wherein the first elementary time interval (I_{F}) is selected by repeating the bit several times in an identical fashion within corresponding read periods (T_{D}), by counting the number (N_{B}) of times where a bit is detected within said first time interval and by comparing the number obtained to a first threshold (T₁).

3. The method according to Claim 1 or 2, wherein step /c/ is repeated using successive time windows (W1-W4) selected in order to perform a scan of a part of a read period (T_{D}).

4. The method according to Claim 3, wherein a last elementary time interval (I_{L}) from the part of the read period corresponding to the scan is selected so that a probability that a detection event time occurs within said last elementary time interval is non-zero, with a large proportion of the detection event times occurring between said first (I_{F}) and last (I_{L}) elementary time intervals within the corresponding read periods (T_{D}).

5. The method according to Claim 4, wherein the last elementary time interval (I_{L}) is selected by repeating the bit several times in an identical fashion within corresponding read periods (T_{D}), by counting the number (N_{B}) of times where a bit is detected within said last elementary time interval and by comparing the number obtained to a second threshold (T₂).

6. The method according to any one of the preceding claims, further comprising evaluating a mean value of the detection time within each read period (T_{D}).

7. The method according to any one of the preceding claims, further comprising evaluating a standard deviation of the detection time within each read period (T_{D}).

8. The method according to any one of the preceding claims, wherein, at step /c/, a different counter is associated with each elementary time interval (I) situated within the time window (W1), and wherein, at each read period (T_{D}), an assignment of the counters to the time intervals is modified as a function of the difference between the frequency corresponding to the read period and the detection frequency.

9. The method according to any one of the preceding claims, wherein each time window selected (W1-W4) comprises five elementary time intervals (1).

10. The method according to any one of the preceding claims, wherein the frequency corresponding to the read period and the detection frequency are 165.275 MHz and 165.000 MHz, respectively.

11. The method according to any one of the preceding claims, wherein at step /c/ the bit is repeated at least 256 times.

12. The method according to any one of the preceding claims, wherein step /c/ is repeated four times using four successive time windows (W1-W4) selected in order to perform a scan of a part of a read period (T_{D}).

13. A test method for an integrated electronic circuit incorporating a binary data receiver (1), said test method comprising characterizing a bit detection event time according to any one of claims 1 to 12.

14. The test method as claimed in Claim 13, implemented for a circuit incorporating an HDMI receiver (1).

15. The test method as claimed in Claim 13 or 14, wherein several characterizations of bit detection event times are performed simultaneously, respectively for several reception channels (100, 101, 102) arranged in parallel with each other within the integrated electronic circuit, using same signals for triggering bit detection event for said reception channels.

16. An integrated electronic circuit, comprising a receiver (1) for binary data transmitted via at least one bit line (2), and a test module (3) for testing said receiver, the module being configured to implement a method according to any one of claims 1 to 12 for characterizing a detection event time, for a bit transmitted via said line.

17. The circuit as claimed in Claim 16, wherein the receiver (1) is an HDMI receiver.

18. The circuit as claimed in Claim 16 or 17, wherein the receiver (1) comprises a three-bitline bus (2), and wherein the test module (3) comprises three selection and counting assemblies (B) respectively associated with the three bit lines, each selection and counting assembly being configured for implementing the method for characterizing a detection event time for a bit transmitted via the corresponding bit line.

19. The circuit according to any one of claims 16 to 18, wherein the receiver (1) comprises a phase-locked loop (103) and, for each bit line, at least one comparator (1000) connected at input to the bit line, the phase-locked loop being adapted to output a trigger signal to the comparator at each period of a clock signal, at a moment determined within said period of the clock signal.

20. The circuit as claimed in Claim 19, wherein the receiver (1) comprises, for each bit line, sixty comparators (1000) connected at input to the bit line, said phase-locked loop (103) being arranged for outputting respective trigger signals to the comparators, distributed within the period of the clock signal.

21. The circuit as claimed in Claim 19 or 20, wherein the phase-locked loop (103) is connected to the comparators (1000) of several bit lines, with a parallel association with respect to said bit lines, so as to output trigger signals simultaneously to the comparators associated in parallel, and wherein the test module (3) is adapted for characterizing simultaneously the detection event times for bits transmitted respectively via said bit lines.

## Patentansprüche

1. Verfahren zur Charakterisierung eines Zeitpunks der Biterkennung innerhalb einer Lesezeit (T_{D}) dieses Bits, wobei mehrere Lesezeiten auf die gleiche Weise in eine bestimmte Anzahl von Elementarzeitintervallen (I) eingeteilt werden, die durch einen Abstand zwischen einer Frequenz, die der Lesezeit entspricht, und einer Frequenz, nach der eine Biterkennung getaktet ist, definiert werden, wobei das Verfahren folgende Schritte umfasst:
/a/ Identifizieren eines ersten Elementarzeitintervalls (I_{F}), für das die Wahrscheinlichkeit, dass ein Zeitpunkt der Biterkennung in diesem ersten Intervall erfolgt, nicht gleich Null ist,
/b/ Auswählen eines Zeitfensters (W1), ausgehend von dem ersten Elementarintervall (I_{F}), welches mehrere aufeinander folgende Elementarintervalle (I) enthält, wobei das Fenster kleiner ist als eine Lesezeit (T_{D}) und einen großen Anteil an Erkennungszeitpunkten enthält;
/c/ mehrmaliges Wiederholen des Bits auf identische Weise in der entsprechenden Lesezeit und Zählen der Anzahl (N_{B}) der Male, wie oft ein Bit während jedes im Fenster (W1) liegenden Elementarzeitintervalls erkannt wird, wobei keine Zählung eines erkannten Bits für ein Elementarzeitintervall, welches sich außerhalb des Fensters befindet, durchgeführt wird,
wobei die Zählungen, die für die Elementarintervalle vorgenommen wurden, die sich in dem Fenster befinden, einen Teil einer statistischen Verteilung von Zeitpunkten der Biterkennung innerhalb der Lesezeiten charakterisieren.

2. Verfahren gemäß Anspruch 1, wobei das erste Elementarintervall (I_{F}) ausgewählt wird, indem das Bit mehrere Male auf identische Weise in den entsprechenden Lesezeiten (T_{D}) wiederholt wird, indem die Anzahl (N_{B}) der Male, wie oft ein Bit in dem ersten Intervall erkannt wird, gezählt wird, und indem die Zahl, die an einer ersten Schwelle (T1) erhaltenen wird, verglichen wird.

3. Verfahren gemäß Anspruch 1 oder 2, wobei der Schritt /c/ wiederholt wird, indem ausgewählte, aufeinander folgende Fenster (W1-W4) zur Durchführung eines Abtastens eines Abschnitts der Lesezeit (T_{D}) verwendet werden.

4. Verfahren nach Anspruch 3, wobei ein letztes Elementarintervall (I_{L}) aus dem Abschnitt der Lesezeit, der dem Abtasten entspricht, derart ausgewählt wird, dass die Wahrscheinlichkeit, dass ein Erkennungszeitpunkt in diesem letzten Intervall vorliegt, nicht gleich Null ist, wobei ein großer Anteil von Erkennungszeitpunkten zwischen dem ersten (I_{F}) und dem letzten (I_{L}) Intervall in den entsprechenden Lesezeiten (T_{D}) vorliegen.

5. Verfahren gemäß Anspruch 4, wobei das letzte Elementarintervall (I_{L}) ausgewählt wird, indem das Bit mehrere Male auf identische Weise in den entsprechenden Lesezeiten (T_{D}) wiederholt wird, indem die Anzahl (NB) der Male, wie oft ein Bit in dem letzten Intervall erkannt wird, gezählt wird, und indem die Zahl, die an einer zweiten Schwelle (T₂) erhaltenen wird, verglichen wird.

6. Verfahren nach irgendeinem der vorhergehenden Ansprüche, welches außerdem eine Auswertung eines Mittelwerts des Erkennungszeitpunkts innerhalb jeder Lesezeit (T_{D}) umfasst.

7. Verfahren nach irgendeinem der vorhergehenden Ansprüche, welches außerdem eine Auswertung des Erkennungszeitpunkts innerhalb jeder Lesezeit (T_{D}) nach dem Abweichungstyp umfasst.

8. Verfahren nach irgendeinem der vorhergehenden Ansprüche, wobei in Schritt /c/ mit jedem Elementarintervall (1), das sich in dem Fenster (W1) befindet, ein unterschiedlicher Zähler verbunden ist, und wobei in jeder Lesezeit (T_{D}) eine Zuordnung der Zähler zu den Intervallen in Abhängigkeit der Abweichung zwischen der Frequenz, die der Lesezeit entspricht, und der Erkennungsfrequenz verändert wird.

9. Verfahren nach irgendeinem der vorhergehenden Ansprüche, wobei jedes ausgewählte Fenster (W1-W4) fünf Elementarintervalle (I) umfasst.

10. Verfahren nach irgendeinem der vorhergehenden Ansprüche, wobei die Frequenz, die der Lesezeit entspricht, und die Erkennungsfrequenz 165.275 MHz bzw. 165.000 MHz betragen.

11. Verfahren nach irgendeinem der vorhergehenden Ansprüche, wobei in Schritt /c/ das Bit wenigstens 256 Mal wiederholt wird.

12. Verfahren nach irgendeinem der vorhergehenden Ansprüche, wobei der Schritt /c/ viermal wiederholt wird, indem vier aufeinander folgende Fenster (W1-W4), die zur Durchführung eines Abtastens eines Abschnitts der Lesezeit (T_{D}) ausgewählt wurden, verwendet werden.

13. Testverfahren einer integrierten elektronischen Schaltung, welche einen Empfänger für binäre Daten (1) umfasst, wobei das Testverfahren die Charakterisierung eines Zeitpunkts der Biterkennung, welche nach irgendeinem der Ansprüche 1 bis 12 durchgeführt wird, umfasst.

14. Verfahren nach Anspruch 13, welches für eine Schaltung durchgeführt wird, die einen der HDMI-Norm entsprechenden Empfänger (1) umfasst.

15. Verfahren nach Anspruch 13 oder 14, wobei mehrere Charakterisierungen von Zeitpunkten des Bitempfangs jeweils für mehrere Empfangskanäle (100, 101, 102), die parallel im Inneren der integrierten elektronischen Schaltung angeordnet sind, gleichzeitig vorgenommen werden, indem die gleichen Auslösesignale zur Biterkennung für diese Empfangskanäle verwendet werden.

16. Integrierte elektronische Schaltung, umfassend einen Empfänger (1) für binäre Daten, die durch wenigstens eine Bitreihe (2) übertragen werden, und ein Testmodul (3) des Empfängers, wobei das Modul zur Durchführung des Verfahrens zur Charakterisierung eines Erkennungszeitpunkts eines durch die Reihe übertragenen Bits gemäß irgendeinem der Ansprüche 1 bis 12 ausgebildet ist.

17. Schaltung nach Anspruch 16, worin der Empfänger (1) der HDMI-Norm entspricht.

18. Schaltung nach Anspruch 16 oder 17, worin der Empfänger (1) einen Bus aus drei Bitreihen umfasst, und worin das Testmodul (3) drei Auswahl- und Zähleinheiten (B) umfasst, die jeweils mit drei Bitreihen verbunden sind, wobei jede Einheit zur Durchführung des Verfahrens zur Charakterisierung eines Erkennungszeitpunkts eines durch die entsprechende Reihe übertragenen Bits ausgebildet ist.

19. Schaltung nach irgendeinem der Ansprüche 16 bis 18, worin der Empfänger (1) eine Phasenverriegelungsschleife (103) und für jede Bitreihe wenigstens einen Komparator (1000), der am Eingang der Bitreihe angeschlossen ist, umfasst, wobei die Phasenverriegelungsschleife zur Abgabe eines Auslösesignals an den Komparator in jeder Taktimpulsperiode zu einem bestimmten Zeitpunkt in der Taktimpulsperiode ausgebildet ist.

20. Schaltung gemäß Anspruch 19, worin der Empfänger (1) für jede Bitreihe sechzig Komparatoren (1000) umfasst, die am Eingang der Bitreihe angeschlossen sind, wobei die Phasenverriegelungsschleife (103) derart angeordnet ist, dass sie die jeweiligen Auslösesignale, die in der Taktimpulsperiode verteilt sind, an die Komparatoren abgibt.

21. Schaltung gemäß Anspruch 19 oder 20, worin die Phasenverriegelungsschleife (103) mit den Komparatoren (1000) der mehreren Bitreihen durch eine Parallelverbindung zwischen den Bitreihen derart verbunden ist, dass Auslösesignale gleichzeitig an die parallel verbundenen Komparatoren ausgegeben werden, und worin das Testmodul (3) zur gleichzeitigen Charakterisierung der Erkennungszeitpunkte der jeweils durch die Reihen übertragenen Bits ausgebildet ist.
